Europäisches Patentamt

European Patent Office

Office européen des brevets

(11) Publication number: **0 474 245 A2**

# EUROPEAN PATENT APPLICATION

(21) Application number: **91115086.0**

(22) Date of filing: **06.09.91**

(51) Int. Cl.5: **G11C 7/00**

(30) Priority: **06.09.90 JP 236086/90**

(43) Date of publication of application:
**11.03.92 Bulletin 92/11**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken Tokyo(JP)**
Applicant: **TOSHIBA MICRO-ELECTRONICS**
**CORPORATION**
**25-1, Ekimaehoncho**

**Kawasaki-ku Kawasaki-shi(JP)**

(72) Inventor: **Doi, Hironori**
**102, Uindia Kitakamakura, 1083, Yamanouchi**
**Kamakura-shi, Kanagawa-ken(JP)**
Inventor: **Ikawa, Tatsuo**
**1-32-11, Inokashira**
**Mitaka-shi, Tokyo-to(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Semiconductor memory device.

(57) In a semiconductor memory device having a random access port for enabling data access at random and a serial access port for enabling data access in series, the transfer gate (15, 17) and the data register (16, 18) of the serial access memory port are divided into two systems, respectively. Therefore, data access operations are alternated in such a way that when data are transferred between one data register (16, 18) and the memory cell array (1), data are transferred between the other data register (16, 18) and an external device.

FIG. I

## BACKGROUND OF THE INVENTION

The present invention relates to a semiconductor memory device, and more specifically to a memory device of dual port structure including a random access port (referred to as RAM port, hereinafter) and a serial access memory port (referred to as SAM port, hereinafter).

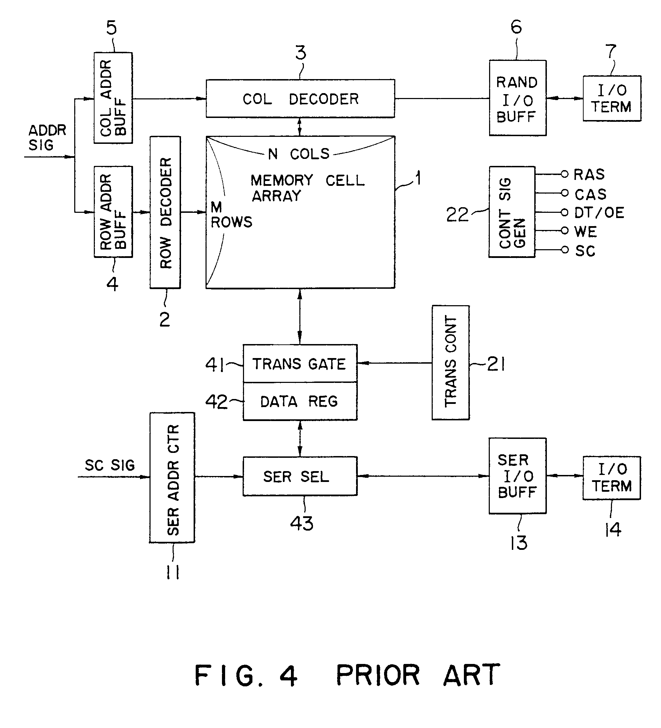

A circuit configuration of a prior-art semiconductor memory device of dual port structure will be described hereinbelow with reference to Fig. 4. The prior-art memory device comprises an M-row and N-column matrix memory cell array 1, a RAM port for effecting data access to an external device at random, and a SAM port for effecting one-row data access to an external device in series. The RAM port is composed of a row address buffer 4, a column address buffer 5, a row decoder 2, a column decoder 3, a random input/output buffer 6, and an input/output terminal 7. The SAM port is composed of a serial address counter 11, a serial selector 43, a data register 42, a serial input/output buffer 13 and an input/output terminal 14.

Various signals for controlling data inputted to and outputted from these RAM port and the SAM port are given from a control signal generating circuit 22 to each elements. These control signals can be roughly classified into RAM-port side control signals and a SAM-port side control signal. The RAM port side control signals are a row address strobe signal (referred to as RAS signal, hereinafter) for reading a row address signal at an appropriate timing, a column address strobe signal (referred to as CAS signal, hereinafter) for reading a column address signal at an appropriate timing, a data transfer control signal (referred to as DT signal, hereinafter) for controlling data transfer between the memory cell array 1 and the data register 42, and a write enable signal (referred to as WE signal, hereinafter) for controlling data write to the memory cell array 1. The SAM port side control signal is a clock signal (referred to as SC signal, hereinafter) for driving the SAM port.

Data access on the RAM port side will be first explained hereinbelow. A row address signal transmitted from a CPU (not shown) is given to the row decoder 2 via the row address buffer 4. Simultaneously, a column address signal is given to the column address decoder 3 via the column address buffer 5. A memory cell data at an address selected by these row decoder 2 and the column decoder 3 is given to the input/output terminal 7 via the random input/output buffer 6, so that the data at the selected address is outputted to an external device. In contrast, a data inputted from an external device via the input/output terminal 7 is stored in a memory cell at an address selected by the row and column address signals. As described above, data access (transfer) can be effected at random between the memory cell array 7 and the external device.

Data access on the SAM port side will be explained hereinbelow. A row address signal is given to the row decoder 2 via the row address buffer 4 to select one row (e.g. the mth row) from the M rows. When a transfer controller 21 commands a transfer gate 41 to transfer data, N-bit data stored along the mth row of the memory cells are transferred to the data register 42 in parallel, so that the transferred mth row data are held by the data register 42.

Thereafter, in response to the SC signal from the CPU (not shown), the serial address counter 11 counts addresses of the data register 42 one by one. The counted address is given to the serial selector 43. The serial selector 43 transfers a data at the counted address of the N-bit data held by the data register 42 one by one in sequence to the serial input/output buffer 13. The transferred data are outputted sequentially to the external device via the serial input/output buffer 13 from the input/output terminal 14.

In contrast, data inputted from the external device via the input/output terminal 14 and the serial input/output buffer 13 can be stored to the memory cells arranged along a row selected by a row address signal. That is, on the basis of addresses counted by the serial address counter 11, the serial selector 43 selects the addresses of the data register 42, and transfers and holds the data in sequence at the selected addresses of the data register 42. Furthermore, when the transfer controller 21 commands the transfer gate 41 to transfer data, the transfer gate 41 transfers data held in the data register 42 in parallel to the first to Nth bit cells arranged along the mth row of the memory cell array, so that data inputted externally can be transferred to and stored at the memory cell array 1.

As described above, on the SAM port side, data access can be effected in series between the external device and the memory cell array 1 via the data register 42. In this operation, however, it is necessary to synchronize the operation such that data held by the data register 42 are outputted to the external device or data inputted externally are held at the data register 42 with the operation such that data are transferred between the memory cell array 1 and the data register 42. In other words, when data are outputted from the memory cell array 1 to the external device, it is necessary to output data from the data register 42 to the external device, after data have been transferred from the memory cell array 1 to the data register 42. Otherwise, old data previously held at the data register 42 are outputted to the external device. In the same way, when data are required to be inputted to the memory cell array 1 from outside, it is necessary to start data transfer from the data register 42 to the memory cell array 1 after data have been inputted to the data register 42 from outside. In addition, it is necessary to prevent data from being inputted to the data register 42 from outside, from when the one-row data have been inputted to the data register 42 from outside to when these data have been transferred from the data register 42 to the memory cell array 1. If not, other data may be mixed in.

In the prior-art memory device, there therefore exists a problem in that the control signals (RAS signal and DT signal) on the RAM port side must be synchronized with the control signal (SC signal) on the SAM port side at specific timing, thus resulting in a severe restriction on device circuit design.

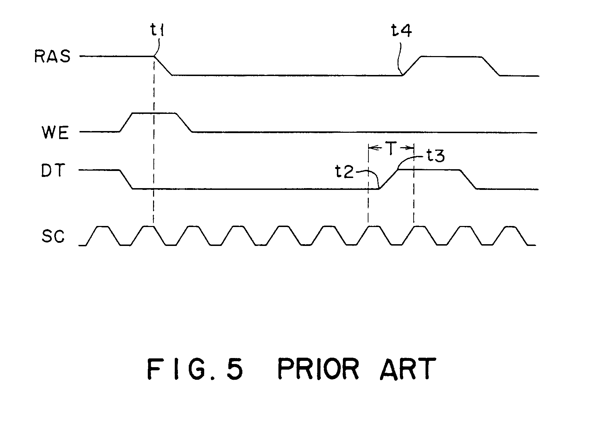

The above-mentioned problem will be explained in further detail with reference to Fig. 5. At a time point $(t_1)$ when the RAS signal level falls from 1 to 0 level, a row address signal is read, and data transfer from the memory cell array 1 to the data register 42 or vice versa is commanded on the basis of the WE signal level at this time point (t1). That is, if the WE signal is at 1 level as shown in Fig. 5, data are transferred from the memory cell array 1 to the data register 42. If at 0 level, data are transferred from the data register 42 to the memory cell array 1. Furthermore, in any case, the DT signal must be kept at the 0 level at this time point (t1). Furthermore, the operation required for these data transfer as described above is executed only when the RAS signal is kept at 0 level. The above operation is reset when the RAS signal level rises from 0 to 1 level at a time point (t4).

First, where data are transferred from the memory cell array 1 to the data register 42, at the time point (t1) when the RAS signal level falls from 1 to 0 level, the WE signal level is set to the 1 level and the DT signal level is set to 0 level to start the operation required for the data transfer processing. Under these conditions, one-row data are transferred in parallel from the memory cell array 1 to the data register 42 between a time point (t2) when the DT signal level begins to rise from the 0 to the 1 level and a time point (t3) when reaches the 1 level.

Here, as already described, the data transfer from the memory cell array 1 to the data register 42 must be synchronized with that between the data register 42 and the external device. The data transfer between the data register 42 and the external device is effected in series by transferring data one by one for each cycle of the SC signal. Therefore, in practice, one-row data are transferred from the memory cell array 1 to the data register 42 at the time intervals during which data are transferred between the data register 42 and the external device one by one or during one cycle of the SC signal. In case data are transferred during two cycles of the SC signal, there exists a problem in that one-row data are discontinued and further other external data are mixed with the one-row data, thus resulting in noise. In particular, when data stored in the memory cell array 1 are image data to be displayed, since noise is displayed on an image screen, the above-mentioned problems must be overcome. Therefore, in order to transfer data continuously, it is necessary to set the time duration from the time point (t2) when the DT signal starts to rise to the time point (t3) when the DT signal reaches the high level (referred to as a rise edge, hereinafter), within one cycle duration (T) of the SC signal.

However, since the one cycle of the SC signal is in general as short as 30 ns, it is extremely difficult to synchronize the DT signal on the RAM port side with the SC signal on the SAM port side, so that the rise edge of the DT signal is set within as short a time duration as described above, thus resulting in a severe restriction on device design.

Furthermore, when data are transferred from the data register 42 to the memory cell array 1, the WE signal and the DT signal are both at 0 level at the time point (t1) when the RAS signal falls from the 1 to the 0 level, and the operation required for data transfer starts beginning from this time point (t1). Under these conditions, at the time point (t2) when the DT signal rises from the 0 to the 1 level, data held in the data register 42 are transferred in parallel to the memory cell array 1. In this case, if data inputted from outside via the input/output terminal 14 are given to the data register 42 beginning from the time point (t1) at which the RAS signal falls (t1) during the time interval when the RAS signal is kept at the 0 level, other data are mixed with the previously stored data. To prevent this problem, it is necessary to stop generating the SC signal while the RAS signal is kept at the 0 level.

As described above, since the RAS signal and the DT signal of the RAM port side control signals must be synchronized with the SC signal of the SAM port side control signal, there exists a problem in that the restriction on the device circuit design is severe and therefore the efficiency of design work is low.

## SUMMARY OF THE INVENTION

Therefore, the object of the present invention is to provide a semiconductor memory device by which it is unnecessary to effect data transfer between the data register and the memory cell array at difficult timing with respect to the data transfer between the data register and an external device; that is, the RAM port side control signals are not required to be synchronized with the SAM port side control signal, in order that the restriction on circuit design can be decreased and the efficiency of design work can be increased.

According to the present invention, a semiconductor memory device of dual port structure having a random access memory port for selecting a memory cell from a memory cell array arranged into an M-row × N-column matrix form by a row decoder for selecting any given row from the M rows and a column decoder for selecting any given column from the N columns, in order to enable data access at random; and a serial access memory port for controlling data transfer between a data register for holding N-bit data and any given one-row memory cells selected by the row decoder through a transfer gate and additionally controlling serial data transfer between the data register and an external device through a serial selector, in order to enable data access in series is characterized in that: the data register comprises a first data register for holding ℓ-bit data and a second data register for holding (N-ℓ) bit data; the transfer gate comprises a first transfer gate for controlling data transfer between the ℓ-piece memory cells of any given one-row memory cells selected by the row decoder and the first data register and a second transfer gate for controlling data transfer between the remaining (N-ℓ) piece memory cells and the second data register; and also a serial selector comprises a first serial selector for controlling data transfer between the first data register and the external device and a second serial selector for controlling data transfer between the second data register and the external device; and the first and second transfer gate alternately control data transfer, and the first and second serial selector also alternately control data transfer. Therefore, when the first transfer gate is transferring data between the ℓ-piece memory cells and the first data register, the second serial selector transfers data between the second data register and the external device. Furthermore, when the second transfer gate is transferring data between the (N-ℓ) piece memory cells and the second data register, the first serial selector transfers data between the first data register and the external device.

In the semiconductor memory device according to the present invention, the transfer gate, the data register and the serial selector are all divided into first and second systems. When the first transfer gate is transferring data between the ℓ-piece memory cells and the first data register, the second transfer gate will not transfer data between the (N-ℓ) piece memory cells and the second data register; however, the second serial selector transfers data between the second data register and the external device. On the other hand, when the second transfer gate is transferring data between the (N-ℓ) piece memory cells and the second data register, the first transfer gate will not transfer data between the ℓ-piece memory cells and the first data register; however, the first serial selector transfers data between the first data register and the external device. As described above, the data transfer control operations between the data registers and the memory cell array and between the data registers and the external device are divided into a first and a second system, respectively, in such a way that when data are transferred between one data register and the memory cell array in one system, data are transferred between the other data register and the external device in the other system. Where data transfer is effected through a single system, it is required that after data have been transferred from the memory cell array to the data register, data are then transferred from the data register to the external device; or after data have been transferred from the external device to the data register, data must be transferred from the data register to the memory cell array under the condition that other data are prevented from being stored in the data register, and thus a rather difficult timing is required. In the memory device according to the present invention, since data transfer is alternately switched through two different systems, it is possible to eliminate difficult timing operation and restrictions on device circuit design.

Furthermore, when the memory device is provided with a means for displaying which of the first and second data registers is effecting data access to the external device, the external device can detect which one of the two data registers has access to the external device.

BRIEF DESCRIPTION OF THE DRAWINGS

Fig. 1 is a block diagram showing one embodiment of the semiconductor memory device according to the present invention;

Fig. 2 is a timing chart showing control signals required to control data transfer from the memory cell array to the data registers in the memory device shown in Fig. 1;

Fig. 3 is a timing chart showing control signals required to control data transfer from the data registers to the memory cell array;

Fig. 4 is a block diagram showing a prior-art semiconductor memory device; and

Fig. 5 is a timing chart showing control signals required to control data transfer from the memory cell array to the data register in the prior-art memory device shown in Fig. 4.

## DESCRIPTION OF THE PREFERRED EMBODIMENTS

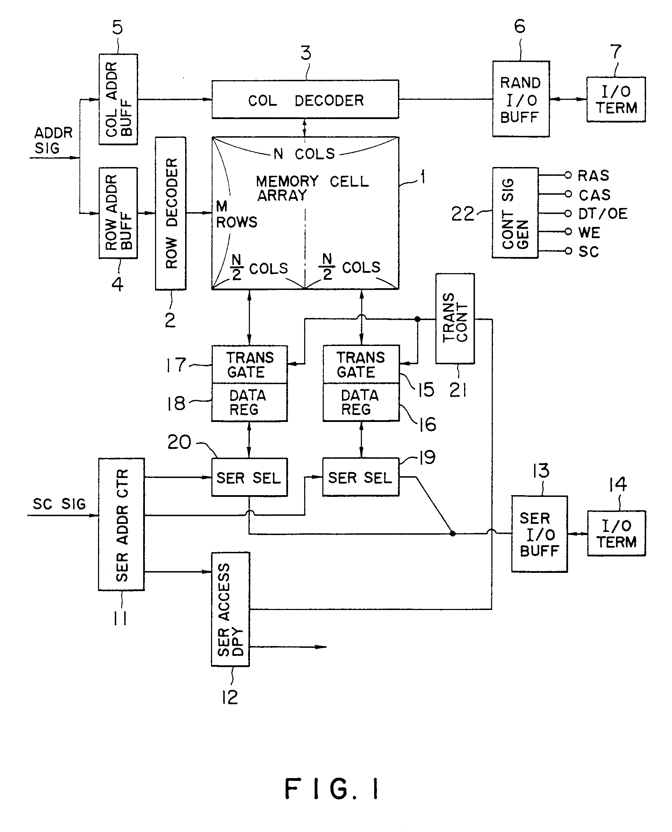

An embodiment of the present invention will be described hereinbelow. Fig. 1 shows the configuration of the embodiment. In comparison with the prior-art memory device shown in Fig. 4, there exists a difference between the two in that the transfer gate is divided into two 15 and 17 and the data register is similarly divided into two 16 and 18 in order that data transfer between the memory cell array 1 and the data register is effected alternately through the two divided systems. Therefore, when data are being transferred between any one of the data registers 16 and 18 and the memory cell array 1, data can be transferred between the other of the data registers and an external device.

Here, the data registers 16 and 18 hold N/2-bit data, respectively. The transfer gate 15 controls data transfer between N/2-column cells of the memory cell array 1 and the data register 16, while the transfer gate 17 controls data transfer between N/2-column cells of the memory cell array 1 and the data register 18.

Furthermore, the serial selector is divided into two 19 and 20 in the same way. In response to a SC signal given from a CPU (not shown), the serial address counter 11 counts in sequence addresses (from the first bit to the N/2th bit) of the data register 16 and addresses (from the (N/2 + 1)th bit to the Nth bit) of the data register 18. These counted addresses are given to the serial selectors 19 and 20, respectively. In accordance with these counted addresses, the serial selector 19 selects addresses from the first bit to the N/2th bit of the data register 16, and the serial selector 20 selects addresses from the (N/2 + 1)th bit to the Nth bit in sequence, respectively.

In response to the address counted by the serial address counter 11, the serial access display section 12 displays which of the data registers 16 and 18 is accessing the external device. For instance, when data are transferred between the data register 16 and the memory cell array 1 and between the data register 18 and the external device, the fact that the data register 18 has access to the external device is displayed. Furthermore, in this case, since the addresses given from the serial address counter 11 to the serial access display section 12 lie within a range from the first bit to the N/2th bit, a 0-level signal, for instance is outputted from the serial access display section 12 to the transfer controller 21. In response to this signal, the transfer controller 21 selects the transfer gate 15, so that the transfer gate 15 controls data transfer between the data register 16 and the memory cell array 1. In contrast with this, when data are being transferred between the data register 18 and the memory cell array 1 and transferred between the data register 16 and the external device, the fact that the data register 16 has access to the external device is displayed. In this case, the addresses lie between the (N/2 + 1)th bit and the Nth bit, and a 1 level signal is outputted from the serial access display section 12 to the transfer controller 21. In response to this signal, the transfer controller 21 selects the transfer gate 17, so that the transfer gate 17 controls data transfer between the data register 20 and the memory cell array 1.

Here, the same reference numerals have been retained for similar composing elements having the same functions as with the prior-art device shown in Fig. 4, without repeating the description thereof.

The operation of the embodiment of the semiconductor memory device according to the present invention as described above will be described hereinbelow. The data access operation on the RAM port side is quite the same as that of the prior-art device, and therefore only the data access operation on the SAM port side will be explained.

When data are transferred from the memory cell array 1 to the outside, a row address signal given via the row address buffer 4 is decoded by the row decoder 2, so that one row (e.g. mth row) of the M rows is selected. The mth row data are transferred via either of the transfer gates 15 and 17, which is selected by the transfer controller when the transfer gate 15 is selected, data stored from the first bit to the N/2th bit arranged along the mth row of the memory cell array 1 are transferred in parallel to and held by the data register 16.

Furthermore, in response to the SC signal given from the CPU (not shown) the serial address counter 11 counts in sequence addresses of the data register 16 beginning from the first bit. These counted addresses are given to the serial selector 19 in sequence. In accordance with these addresses, the serial selector 19 transfers data from the first bit to the N/2th bit stored in the data register 16 to the serial input/output buffer 13 sequentially. These transferred data are outputted in series via the serial input/output buffer 13 from the input/output terminal 14 to outside.

When data are being outputted from the data register 16 to outside as described above, the remaining data from the (N/2 + 1)th bit to the Nth bit are transferred from the memory cell array 1 to the data register 18. When the counted value of the serial address counter 11 reaches a value of N/2 + 1, the transfer controller 21 selects the transfer gate 17 in response to a select signal from the serial access display section 12, so that the transfer gate 17 transfers in parallel data from the (N/2 + 1)th bit to the Nth bit arranged along the mth row of the memory cell array 1 to the data register 18. Therefore, data from the (N/2 + 1)th bit to the Nth bit arranged along the mth row are held by the data register 18.

On the basis of addresses counted by the serial address counter 11, the serial selector 20 transfers data one by one from the (N/2 + 1)th bit to the Nth bit held by the data register 18 to the serial input/output buffer 13. These data are outputted in sequence via the serial input/output buffer 13 from the input/output terminal 14 to outside. As described above, mth row data stored in the memory cell array 1 are outputted in series to the external device.

When data are being outputted from the data register 18 to the external device, the succeeding row (e.g. (m+1)th row) is selected by the row decoder 2. The transfer gate 15 is selected by the transfer controller 21, so that data from the first bit to the N/2th bit arranged along the (m+1)th row of the memory cell array 1 are transferred in parallel to and held by the data register 16.

As described above, when data are being transferred from the memory cell array 1 to one of the data registers, data are outputted from the other of the data register to outside, with the result that the above two data transfer operations are effective alternately.

The operation that data inputted from the external device via the input/output terminal 14 are stored to mth-row memory cells selected by a row address signal will be described hereinbelow. Data are given in sequence from the input/output terminal 14 to the serial input/output buffer 13. Furthermore, address data from 1 to N/2 counted by the serial address counter 11 are given to the serial selector 19 and those from N/2 + 1 to N are given to the serial selector 20. Data from the first bit to the (N/2 + 1)th bit are transferred from the serial selector 19 to the data register 16 in sequence and held by the data register 16.

Furthermore, the transfer gate 15 selected by the transfer controller 21 transfers data in parallel from the data register 16 to the mth row of the memory cell array 1 beginning from the first bit cell to the N/2 bit cell.

When data are being transferred from the data register 16 to the memory cell array 1, data transferred to the serial selector 20 are further transferred in sequence to and held by the data register 18.

When the transfer gate 17 selected by the transfer controller 21 is transferring data held by the data register 18 in parallel to the memory cell array 1, the succeeding (m+1)th row is selected to transfer data from outside to the data register 16.

As described above, when data are transferred in series between the memory cell array 1 and the external device (i.e. serial data access to the memory cell array 1), the two data registers are used alternately and separately. That is, when data are being transferred between the data register 16 and the memory cell array 1, data are transferred between the data register 18 and the external device. Furthermore, when data are being transferred between the data register 16 and the external device, data are transferred between the data register 18 and the memory cell array 1.

The relationship between the control signals on the RAM port side and the control signal on the SAM port side will be explained hereinbelow.

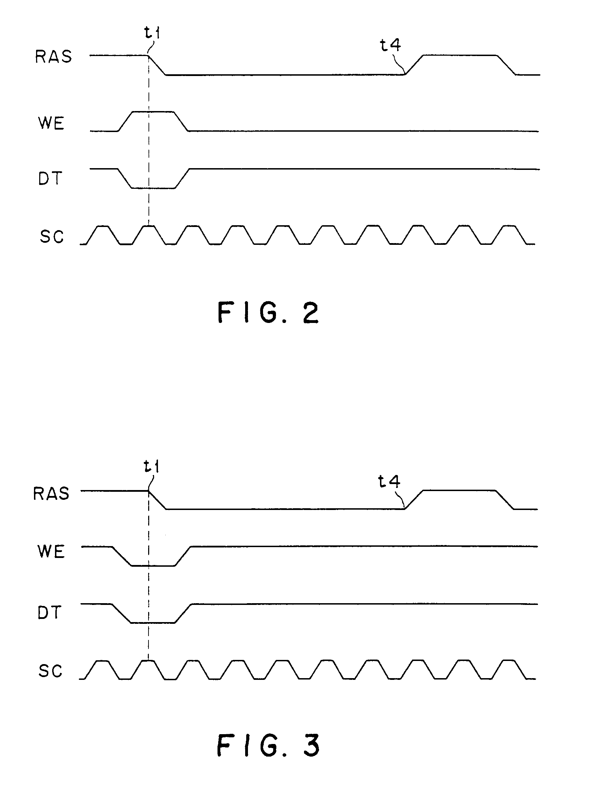

In the same way as with the case of the prior-art device, at a time point (t1) when the RAS signal falls from 1 to 0 level, the WE signal is at 1 level as shown in Fig. 2. Under these conditions, if the DT signal is at 0 level, data are transferred from the memory cell array 1 to either of the data register 16 or 18. On the other hand, when the WE signal and the DT signal are both at 0 level, data are transferred from either of the data registers 16 or 18 to the memory cell array 1. The operation required for data transfer starts at the time point (t1) and is reset at the time point (t4) when the RAS signal rises from 0 to 1 level.

The data transfer from the memory cell array 1 to the data register will be first explained. When data from the first bit to the N/2th bit are transferred between the data register 16 and the external device, since the data register 18 is idle, data can be transferred between this idle data register 18 and the memory cell array 1, without preventing data access between the data register 16 and the external device. In contrast, when data from the (N/2 + 1)th bit to the Nth bit are accessed between the data register 18 and the external device, since the data register 16 is idle, data can be transferred between this idle data register 16 and the memory cell array 1.

In the prior-art device, data are transferred between the memory cell array 1 and the data register by use of the data register 42 and the transfer gate 41, that is, through a single system. Therefore, the data transfer between the memory cell array 1 and the data register 42 must be effected in synchronism with the data transfer between the data register 42 and the external device at appropriate timing, that is, within one cycle of the SC signal as shown in Fig. 5 in order to prevent noise, thus resulting in an extremely difficult data transfer timing. In the present invention, however, since data transfer between the memory cell array 1 and the data register is effected through two divided systems in such a way that when data are transferred between one of the data registers and the external device, data are transferred from the memory cell array 1 to the other of the data registers, it is possible to eliminate the difficult data transfer timing. In other words, since it is unnecessary to synchronize the DT signal of the RAM port side control signals with the SC signal of the SAM port side control signal, the circuit design efficiency can be improved, without causing restrictions on device circuit design.

The data transfer from the data registers to the memory cell array 1 will be explained. In the same way, when data are being transferred between the data register 16 and the external device, data can be transferred from the other data register 18 to the memory cell array 1. In contrast, when data are being transferred between the data register 18 and the external device, data can be transferred from the data register 16 to the memory cell array 1. In the prior-art device, the SC signal must be kept stopped from the time point (t1) when the RAS signal falls to the time point (t4) when the RAS signal rises to prevent data newly inputted from outside from being mixed with data held in the data register 42. In the case of the present invention, however, since data transfer control between the data register and the memory cell array 1 is divided into two systems; that is, since when one of the data registers is being used for data transfer to the memory cell array 1, no data are transferred to this data register from outside but data are transferred to the other idling data register, there exists no problem with data mixture. Therefore, it is unnecessary to synchronize the RAS signal of the RAM port side control signals with the SC signal on the SAM port side control signal, and differs from the conventional devices, in that the circuit design efficiency is improved without severe restrictions on the design.

In addition, since one of the data registers 16 and 18 used for serial data access to the external device can be displayed by the serial access display section 12, it is possible to check the current access status by the external device for transferring data to the data registers.

The above-mentioned embodiment has been described only by way of example, and therefore the present invention is not limited thereto. For example, in the above-mentioned embodiment, data transfer between the memory cell array and the data register has been divided into two routes. However, it is possible to divide the data transfer into three or more routes. Furthermore, the present invention can be applied to the circuit different in configuration from that shown in Fig. 1, as far as signals for controlling data transfer between the memory cell array and the data registers are divided into two or more systems for control operation, in the semiconductor memory device of dual port structure including the RAM port and the SAM port.

Reference signs in the claims are intended for better understanding and shall not limit the scope.

**Claims**

1. A semiconductor memory device having a memory cell array (1) in which a plurality of memory cells are arranged into an M-row and N-column matrix form, characterized in that the semiconductor memory device comprises,

   (a) a random access memory port for enabling random data access, having a row decoder (2) for selecting any given row of the M rows of the memory cell array (1) and a column decoder (3) for selecting any given column of the N columns of the memory cell array (1); and

   (b) a serial access memory port for enabling serial data access, having:

      (1) a data register including a first data register (16) for holding an $\ell$-bit data, where $\ell$ denotes an integer from 1 to N, and a second data register (18) for holding an (N-$\ell$) bit data;

      (2) a transfer gate including a first transfer gate (15) for controlling data transfer between $\ell$-piece memory cells of any given row selected by said row decoder (2) and said first data register (16) and a second transfer gate (17) for controlling data transfer between remaining (N-$\ell$)-piece memory cells of the selected row and the second data register (18);

      (3) a serial selector including a first serial selector (19) for controlling data transfer between said first data register (16) and an external device and a second serial selector (20) for controlling data transfer between said second data register (18) and the external device;

      said first and second transfer gates (15, 17) controlling data transfer alternately, and said first and second serial selectors (19, 20) similarly controlling data transfer alternately;

      when said first transfer gate (15) is transferring data between the $\ell$-piece memory cells and said first data register (16), said second serial selector (20) transfers data between said second data register (18) and the external device; and

      when said second transfer gate (17) is transferring data between the (N-$\ell$) piece memory cells and said second data register (18), said first serial selector (19) transfers data between said first data register (16) and the external device.

2. The semiconductor memory device of claim 1, which further comprises means for displaying (12) which of said first and second data registers (16, 18) is effecting data access.

FIG. 1

FIG. 2

FIG. 3

FIG. 4 PRIOR ART

FIG. 5    PRIOR ART